Europäisches Patentamt

European Patent Office

Office européen des brevets

(19)

(11) Veröffentlichungsnummer : **0 165 413 B2**

# (12) NEUE EUROPÄISCHE PATENTSCHRIFT

(45) Veröffentlichungstag der neuen Patentschrift :
25.09.91 Patentblatt 91/39

(51) Int. Cl.⁵ : **C23C 14/34**

(21) Anmeldenummer : 85105070.8

(22) Anmeldetag : 26.04.85

(54) Verfahren zum Aufbringen von optischen Schichten aus Siliziumverbindungen durch Katodenzerstäubung und Verwendung eines Siliziumformkörpers als Target zur Durchführung des Verfahrens.

(30) Priorität : 12.05.84 DE 3417732

(43) Veröffentlichungstag der Anmeldung :
27.12.85 Patentblatt 85/52

(45) Bekanntmachung des Hinweises auf die
Patenterteilung :
17.11.88 Patentblatt 88/46

(45) Bekanntmachung des Hinweises auf die
Entscheidung über den Einspruch :
25.09.91 Patentblatt 91/39

(84) Benannte Vertragsstaaten :
AT CH DE FR GB IT LI NL

(56) Entgegenhaltungen :
DE-A- 2 944 382
DE-A- 3 206 413
US-A- 4 175 610
US-A- 4 187 827
JOURNAL OF APPLIED PHYSICS, Band 50, Nr.
11, part 1, November 1979, Seiten 7034-7038,
New York, US; F.R. JEFFREY et al.: "Control of
dihydride bond density in reactive sputtered
amorphous silicon"
NAVY TECHNICAL DISCLOSURE BULLETIN,
Band 8, Nr. 4, Juni 1983, Seiten 59-62, Washington, US; A.S. EDELSTEIN et al.: "Simple
method for preparing solid sputtering targets
of alloys, compounds and brittle materials"
PATENTS ABSTRACTS OF JAPAN, Band 7, Nr.
34 (C-150) [1179], 10 Februar 1983
JOURNAL OF THE ELECTROCHEMICAL SO-
CIETY, Band 112, Nr. 10, Oktober 1965, Seiten
1050-1051, Redondo Beach, Ca, US; M.
BLOOM et al.: "The preparation of large-area
silicon cathodes for use in reactive sputtering"
PATENTS ABSTRACTS OF JAPAN, Band 6, Nr.
73 (C-101) [951], 8 Mai 1982
PATENTS ABSTRACTS OF JAPAN, Band 7, Nr.
13 (E-153) [1158], 19 Januar 1983
PATENTS ABSTRACTS OF JAPAN, Band 6, Nr.
6 (E-89) [884], 14 Januar 1982
Wacker Technical Information 03.80 Isue date
;1980.10.01 "Silso a type of large-area polycrystalline silicon.."

(56) Entgegenhaltungen :
Solid State Technology, June 1988, S. 113-117
"Amorphous Silicon and its Application",C.R.
Wronski.
Physics of Semiconductor Devices, 2nd Edition, J. Wiley & Sons, 1981, von S.M.Sze, S.
827-828 (Figur 34).

(73) Patentinhaber : LEYBOLD
AKTIENGESELLSCHAFT
Wilhelm-Rohn-Strasse 25
W-6450 Hanau am Main 1 (DE)

(72) Erfinder : Wirz, Peter, Dr.
Klosterstrasse 5
W-6296 Waldernbach (DE)

(74) Vertreter : Zapfe, Hans, Dipl.-Ing.
Am Eichwald 7, Postfach 20 01 51
W-6056 Heusenstamm 2 (Rembrücken) (DE)

EP 0 165 413 B2

## Beschreibung

Die Erfindung betrifft ein Verfahren nach dem Oberbegriff des Patentanspruchs 1.

Es ist bekannt, für die Herstellung von Schichten aus Siliziumverbindungen plattenförmiges Targetmaterial zu verwenden, das aus Siliziumpulver unter Zusatz von Materialien wie Aluminium und Lithium zur Erzeugung einer elektrischen und Erhöhung der thermischen Leitfähigkeit unter hoher Verdichtung gepresst worden ist.

Die Verdichtung wird dabei zur Erzielung einer grossen Dichte des Targetmaterials bei hohen Temperaturen in der Grössenordnung von 2000°C vorgenommen. Durch den komplizierten Herstellprozess sind derartige Targets sehr teuer. Z.B. kostet eine Targetplatte mit den Abmessungen 70 cm x 25 cm x 1 cm zwischen DM 25 000. und DM 40 000.-. Dabei hat heissgepresstes Targetmaterial den Nachteil, dass aufgrund seiner nach wie vor körnigen bzw. porigen Beschaffenheit eine grosse Oberfläche gebildet wird. Hierdurch ist eine längere Zeitdauer für den Reinigungsprozess des Targetmaterials bei jeder neuen Charge erforderlich. Man versteht hierunter eine Vorzerstäubung von der Targetoberfläche auf eine vorübergehend zwischen das Target und die Substrate eingeschobene Platte oder Blende. Die entsprechend lange Zeitdauer für den Reinigungsprozess hat einen entsprechenden Materialverlust zur Folge, führt aber auch zu einer geringeren Wirtschaftlichkeit der Zerstäubungsanlage, da sich der eigentliche Beschichtungsprozess erst an den Reinigungsprozess anschliesst.

Weiterhin ist die Oberfläche eines gepressten Werkstoffs im mikroskopischen Sinne rauh ausgebildet, und in der Oberfläche können sich im weiteren Verlauf des Zerstäubungsvorganges sogenannte Spitzen oder Buckel ausbilden. Dies ist wesentlich auf die unterschiedlichen Zerstäubungsraten der im Targetmaterial enthaltenen Komponenten, also z.B. Aluminium und Lithium, zurückzuführen. An den Spitzen tritt wegen der schlecht wärmeleitenden Verbindung mit dem übrigen Material eine lokale Überhitzung auf, wodurch Feststoffpartikel des Targetmaterials aus der Targetplatte herausgesprengt werden. Selbst wenn diese Partikel nicht mit den Substraten in Berührung kommen, wirkt sich dieser Vorgang doch negativ auf das Schichtwachstum bzw. die Schichthomogenität auf dem Substrat aus.

Bei der reaktiven Katodenzerstäubung handelt es sich vornehmlich um einen Oxidationsvorgang während der Beschichtung, d.h. im Reaktionsgas ist Sauerstoff enthalten, und es werden Oxide des Siliziums, überwiegend $SiO_2$, gebildet. Analoge Überlegungen gelten aber naturgemäss auch für andere Reaktionsgase, beispielsweise für Stickstoff, wenn auf den Substraten Siliziumnitrid gebildet werden soll.

Die vorstehend beschriebenen reaktiven Prozesse sind auch nicht frei von Rückwirkungen auf die Targetmaterialien. Bei heissgepressten Targetmaterialien besteht ganz besonders die Neigung, dass auf der Zerstäubungsoberfläche zumindest örtlich Schichten des Reaktionsproduktes mit dem Reaktionsgas gebildet werden, bei Verwendung von Sauerstoff also beispielsweise Siliziumdioxid. Derartige Reaktionsprodukte sind elektrische Nichtleiter, so dass der Zerstäubungsprozess zumindest örtlich behindert wird, jedenfalls solange, wie keine Hochfrequenz für den Zerstäubungsprozess verwendet wird. Wegen des geringeren technischen Aufwandes ist man jedoch bestrebt, nach Möglichkeit die sogenannte Diodenzerstäubung anzuwenden, gegebenenfalls auch mit einer Magnetfeldunterstützung des Zerstäubungsprozesses, um die ansonsten geringe Zerstäubungsrate um mindestens eine Zehnerpotenz heraufzusetzen. Das klassische heissgepresste Targetmaterial führt hierbei jedoch zu den vorstehend aufgeführten Problemen.

Durch den Aufsatz von Thornton/Hoffmann « Internal Stresses in Amorphous Silicon Films Deposited by Cylindrical Magnetron Sputtering using Ne, Ar, Kr, Xe, and Ar + $H_2$", veröffentlicht in J. Vac. Sci. Technol., 18 (2), März 1981, Seiten 203 bis 207, ist es bekannt, stabförmiges, aus einer Schmelze gezogenes polykristallines Silizium als Katode in einem Zerstäubungsprozess zu verwenden, wobei die Katode zur Erzeugung der erforderlichen elektrischen Leitfähigkeit mit Dotierungsstoffen versehen wird, die durch einen ausserordentlich langwierigen Diffusionsprozess in das Katodenmaterial eingebracht werden müssen. Das beschriebene Katodenzerstäubungsverfahren ist nicht Teil eines Produktionsprozesses und dient nur zur Untersuchung innerer Spannungen in den dadurch hergestellten Schichten. Die Stabform der Katode bedingt die Einschaltung einer engen Spaltblende, so dass ein sehr grosser Teil des von der Katode abgestäubten Materials auf der Blende und nicht auf dem Substrat niedergeschlagen wird. Im übrigen befasst sich dieser Stand der Technik mit der Herstellung von Schichten mit speziellen elektrischen Eigenschaften und nicht mit Schichten für optische Anwendungszwecke.

Durch die Veröffentlichung von Severin « Materialien für die Kathoden-Zerstäubung ». Vakuum-Technik, 33. Jahrgang, Heft 1, Seiten 3 bis 9, ist es auch bekannt, Gusstargets aus einer Aluminium-Silizium-Legierung herzustellen. Der Aluminiumanteil ist jedoch sehr hoch, denn das Aluminium soll nicht nur eine gute elektrische Leitfähigkeit erzeugen, die ein Zerstäuben mit Gleichspannung ermöglicht, sondern auch eine plastische mechanische Verformung zum Zwecke einer nachträglichen « Kornfeinung » ermöglichen. Mit derartigen Targets lassen sich jedoch keine homogenen Schichten aus praktisch reinem Siliziumoxid erzeugen, da mindestens Aluminiumoxid ein wesentlicher Bestandteil der Schichten ist und sich Silizium und Aluminium beim Zerstäuben unterschiedlich verhalten, so dass sich die relativen Anteile der Oxide mit fortschreitendem Targetverbrauch verschieben.

Optische Schichten aus Siliziumverbindungen, insbesondere solche aus Siliziumoxid ($SiO_2$) spielen jedoch in der heutigen Beschichtungstechnik eine entscheidende Rolle, sei es als abschliessende Schutzschicht auf grossflächigen Substraten wie beispielsweise Fensterscheiben, sei es als Schichtmaterial für Vielfachschichten, die aus abwechseld hoch- und niedrigbrechendem Schichtwerkstoff aufgebaut sind (sogenannte Interferenz-Filter).

Der Erfindung liegt daher die Aufgabe zugrunde, ein Verfahren der eingangs beschriebenen Gattung anzugeben, bei dem die Ausnutzung des zu mindestens 99% aus Silizium bestehenden Targetmaterials, der sogenannte Materialwirkungsgrad, erhöht und die Gefahr des Heraussprengens von Partikeln aus dem Targetmaterial beseitigt, zumindest aber stark reduziert wird.

Die Lösung der gestellten Aufgabe erfolgt bei dem eingangs beschriebenen Verfahren erfindungsgemäss durch die Merkmale im Kennzeichen des Patentanspruchs 1.

Bei dem erfindungsgemässen Verfahren wird also der Formkörper, in der Regel eine von planparellelen Flächen begrenzte Platte durch einen Giessvorgang aus schmelzflüssigem Material erzeugt, wobei sich polykristallines Silizium ausbildet. Es handelt sich dabei um praktisch reines Silizium, das nur Dotierungsstoffe im ppm-Bereich enthält und mechanisch nicht umformbar ist. Bei einem derartigen Giessvorgang lassen sich die Dotierungsstoffe durch einfaches Zumischen homogen in der Schmelze verteilen, so dass ein zeitaufwendiger Diffussionsvorgang überflüssig ist. Die genannten Dotierungsstoffe dienen nur zur Herbeiführung einer ausreichenden Leitfähigkeit während des Zerstäubungsvorganges, nicht aber zur Erzeugung einer definierten Leitfähigkeit der niedergeschlagenen Schichten; dies ist allenfalls eine Begleiterscheinung von sekundärer Bedeutung.

Sofern das Target durch einen quaderförmigen Formkörper gebildet wird, lässt sich dieser leicht auf einem Katodengrundkörper befestigen, der in der Regel durch einen Wasserkreislauf intensiv gekühlt wird. Dadurch lässt sich auch die Target-platte intensiv kühlen. Weitere Vorteile bei plattenförmigen Targets sind die geringen Material-verluste und der hohe Wirkungsgrad beim Beschichten von ebenen Substraten.

Beim Zerstäubungsvorgang zeigt sich zunächst einmal, dass auch im mikroskopischen Bereich eine glatte Oberfläche des Targets erhalten bleibt, die weit weniger zur Oxydation neigt als gesinterte oder gepresste und damit poröse Targetplatten. Auch hat eine solche Platte ausreichende und vor allem gleichmässige wärmeleitende Eigenschaften, so dass lokale Überhitzungen nicht mehr möglich sind. Infolgedessen kann die elektrische Leistung pro Flächeneinheit des Targetmaterials beträchtlich erhöht werden, womit auch die Zerstäubungsrate entsprechend erhöht wird. Dennoch wurde kein Heraussprengen von Oberflächenpartikeln aus dem Targetmaterial beobachtet. Wegen des dadurch bedingten gleichmässigeren Zerstäubungsvorganges konnte auch eine grössere Homogenität innerhalb der erzeugten Schichten eingehalten werden. Die Kosten für eine erfindungsgemässe Targetplatte mit den oben genannten Abmessungen belaufen sich nur auf einen Bruchteil der Kosten für eine entsprechende heissgepresste Targetplatte.

Vor allem aber enthalten die niedergeschlagenen Schichten praktisch keine Dotierungsstoffe mehr, da diese beim Zerstäubungsvorgang durch Abpumpen bzw. Evakuieren verringert werden und die Substrate nicht erreichen können. Aus diesem Grunde sind die Brechungsindices der erzeugten Schichten identisch zu denjenigen, die durch reaktives Zerstäuben von undotiertem Material durch Hochfrequenz erzeugt werden.

Die Erfindung ist anwendbar bei einer Zerstäubungs katode zur Durchführung des erfindungsgemässen Verfharens in Verbindung mit einer sogenannten Magnetronkatode, bei der die Plasmaentladung durch einen geschlossenen Tunnel aus Magnetfeldlinien auf einen engen Raum in unmittelbarer Nähe der Targetoberfläche beschränkt ist.

Die Erfindung beziehtside auch auf die Verwendung eines Formkörpers nach Anspruch 2 als Target für die Durchführung des Verfahrens nach Anspruch 1.

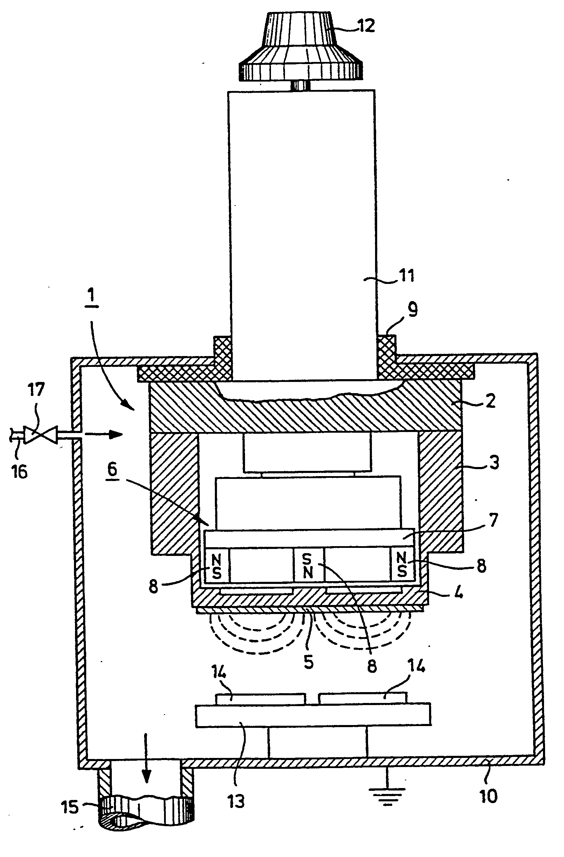

Ein Ausführungsbeispiel einer Vorrichtung zur Durchführung des erfindungsgemässen Verfahrens wird nachfolgend anhand der einzigen Figur näher erläutert, die einen teilweisen Vertikalschnitt durch eine vollständige Vorrichtung zeigt.

In der Figur ist eine Katodenanordnung 1 mit einer Tragplatte 2 dargestellt, die über einen Isolator 9 an der oberen Begrenzungswand einer Vakuumkammer 10 befestigt ist. An der Tragplatte 2 sind wiederum alle funktionswesentlichen Teile der Katodenanordnung befestigt. Hierzu gehört ein wannenförmiger Hohlkörper 3, der aus einem a-magnetischem Werkstoff wie beispielsweise Kupfer besteht und lösbar mit der Tragplatte 2 verbunden ist. Der Hohlkörper 3 besitzt einen Boden 4, der zur Tragplatte 2 parallel verläuft und auf dem eine dem Verbrauch unterliegende Targetplatte 5 aus dem erfindungsgemäss gegossenen Silizium befestigt ist. Die Befestigung kann dabei auf herkömmliche Weise, beispielsweise durch ein lötmaterial erfolgen.

Im Innern des Hohlkörpers 3 befindet sich ein Magnetsystem 6, welches aus einer zur Tragplatte 2 parallelen Magnethalteplatte 7 sowie aus einer Gruppierung von Permanentmagneten 8 besteht, die an der Magnethalteplatte 7 befestigt sind. Die Magnete 8 sind mit abwechselnder Polanordnung auf der Rückseite der Targetplatte 5 angeordnet. Durch die Polung sowie die relative Lage der Magnete zur Targetplatte haben die Feldlinien den gestrichelt angedeuteten Verlauf, d.h. die von einem Pol ausgehenden Feldlinien treten durch die Targetplatte aus und nach einem bogenförmigen Verlauf im Bereich des anderen Poles in die Targetplatte wieder ein. Aufgrund dieses Verlaufs der Magnetfeldlinien wird ein sogenannter magnetischer Tunnel gebildet, welcher es erlaubt, die Zerstäubungsrate wesentlich zu erhöhen, gleichzeitig aber dazu führt, dass das Targetmaterial im Bereich des Tunnels stärker abgetragen wird, am stärksten in der Mitte eines jeden Tunnels.

Zwischen der Magnethalteplatte 7 einerseits und der Tragplatte 2 andererseits ist eine nicht im Detail erläuterte Verstelleinrichtung 11 angeordnet, die durch einen Einstellknopf 12 betätigbar ist, und durch die der Abstand des Magnetsystems 6 von der Targetplatte 5 veränderbar ist. um beispielsweise den Einfluss der beim Zerstäubungsprozess zunehmend tieferen Zerstäubungs- oder Erosionsgräben auszugleichen.

Die Katodenanordnung 1 ist an eine gleichfalls nicht gezeigte Gleichspannungsquelle angeschlossen, die eine geeignete Zerstäubungsspannung zwischen etwa 200 und 800 Volt liefert. Gleichfalls nicht gezeigt ist der die Seitenwände der Katodenanordnung 1 umgebende, auf Massepotential liegende Schirm, der die Ausbildung von Glimmentladungen an diesen unerwünschten Stellen verhindert. Bezüglich weiterer Einzelheiten, die mit Ausnahme des Targetmaterials zum Stande der Technik gehören, wird auf die DE-OS 3 047 113 verwiesen.

In der Vakuumkammer 10 ist gegenüber der Targetplatte 5 ein Substrathalter 13 angeordnet, auf dem die zur Beschichtung vorgesehenen Substrate 14 gelagert sind. Die Vakuumkammer 10 ist über eine nur angedeutete Saugleitung 15 mit einem Satz Vakuumpumpen verbunden, durch die in der Vakuumkammer 10 ein für den Zerstäubungsprozess geeigneter Druck zwischen $5 \times 10^{-2}$ und $10^{-4}$ mbar erzeugt werden kann. Das für den Zerstäubungsprozess erforderliche Reaktionsgas wird über eine Leitung 16 mit einem Dosierventil 17 zugeleitet.

## Beispiel

In einer Vorrichtung gemäss der einzigen Figur wurden Substrate aus optischem Glas mit den Abmessungen 20 cm x 20 cm x 0.5 cm auf dem Substrathalter 13 angeordnet. Der Abstand der Substratoberfläche von der Oberfläche der Targetplatte 5 betrug 20 cm. Die Targetplatte war aus « Kacheln » in der Grösse von 10 cm x 10 cm zusammengesetzt und besass Oberflächenabmessungen von 80 cm x 20 cm

und eine Dicke von 10 mm. Als Targetmaterial wurde mit Bor dotiertes Silizium mit einem spezifischen Widerstand von etwa 3 $\Omega$cm verwendet, welches in geschmolzenem Zustand in einer Giessform durch polykristalline Erstarrung hergestellt wurde.

Nach der üblichen Vorevakuierung wurde die Oberfläche der Targetplatte 5 in Richtung auf eine oberhalb der Substrate 14 eingeschobene Platte für die Dauer von 5 Minuten gereinigt. Nach Beendigung des Reinigungsprozesses wurde in der Vakuumkammer 10 durch laufendes Einlassen eines Gemisches aus Argon und Sauerstoff im Verhältnis 10:1 ein Druck von $10^{-2}$ mbar eingestellt. Bei dem nunmehr für die Dauer von 3 Minuten durchgeführten Zerstäubungsprozess wurde auf den Substraten eine Schicht aus $SiO_2$ mit einer Dicke von 420 nm niedergeschlagen. Bei einer Zerstäubungsspannung von 585 Volt und einem zur Masse fliessenden Strom von 35 Ampere errechnet sich eine spezifische Zerstäubungsleistung von 12,8 W/cm$^2$ bezogen auf die freie Oberfläche der Targetplatte 5. Die spezifische Zerstäubungsleistung kann als verhältnismässig sehr hoch angesehen werden (im Vergleich zu etwa 6 W/cm$^2$ bei einer heissgepressten Targetplatte).

Dennoch konnte kein Heraussprengen von Partikeln aus der Targetplatte beobachtet werden. Die Schichtdickenabweichungen lagen unter 3%.

Bei den sich auf den Siliziumgehalt des Targets beziehenden Prozentangaben handelt es sich um Gewichtsprozente.

## Patentansprüche

1. Verfahren zum Aufbringen von optisch transparenten Schichten aus Verbindungen des Siliziums auf Substraten durch reaktive Katodenzerstäubung von siliziumhaltigen Targetmaterialien, dadurch gekennzeichnet, daß als Targetmaterial ein gegossener und aus dem Schmelzzustand erstarrter polykristalliner Siliziumformkörper aus mindestens 99 % Silizium mit der Schmelze zugemischt Dotierungsstoffen aus der Gruppe Bor, Antimon, Phosphor und Arsen in einer ein Reaktionsgas aus der Gruppe Sauerstoff und Stickstoff enthaltenden Atmosphäre mittels Gleichspannung zerstäubt wird.

2. Verwendung eines Formkörpers aus siliziumhaltigem Werkstoff, der aus einem gegossenen und aus dem Schmelzzustand erstarrten polykristallinen Material aus mindestens 99% Silizium mit der Schmelze zugemischen Dosierungsstoffen aus der gruppe Bor, Antimon, Phosphor und Arsen besteht, als Target zur Durchführung des Verfahrens gemäß Anspruch 1.

3. Verwendung eines Formkörpers nach Anspruch 2, der einen spezifischen Widerstand von 0,1 m$\Omega$cm bis 100 $\Omega$cm aufweist.

4. Verwendung eines Formkörpers nach

Anspruch 3, der einen spezifischen Widerstand von 0,5 bis 10 $\Omega$cm aufweist.

à 10 $\Omega$cm.

## Claims

1. Process for the deposit of transparent optical layers of compounds of silicon on to substrates by reactive cathodic sputtering of silicon-containing target materials, characterized in that a cast polycrystalline silicon moulding which has solidified from the molten state and contains at least 99% silicon with doping substances added to the melt and from the group comprising boron, antimony, phosphorus and arsenic is subjected to sputtering as the target material by means of a direct voltage in an atmosphere containing a reaction gas from the group comprising oxygen and nitrogen.

2. Use of a moulding made of silicon-containing material comprising a cast polycrystalline material solidified from the molten state and containing at least 99% silicon and doping substances added to the melt and from the group comprising boron, antimony, phosphorus and arsenic, as a target for working the process according to claim 1.

3. Use of a moulding according to claim 2, and having a specific resistance of 0.1 m$\Omega$cm to 100 $\Omega$cm.

4. Use of a moulding according to claim 3, and having a specific resistance of 0.5 to 10 $\Omega$cm.

## Revendications

1. Procédé pour appliquer des couches optiques transparentes consistant en composés du silicium sur des substrats, par pulvérisation cathodique réactive de matières de cible contenant du silicium, caractérisé en ce que l'on utilise en tant que matière de cible un corps moulé en silicium polycristallin coulé à l'état fondu et solidifié consistant en au moins 99 % de silicium avec des agents dopants du groupe du bore, de l'antimoine, du phosphore et de l'arsenic mélangés à la masse fondue, qu'on pulvérise sous tension continue dans une atmosphère contenant un gaz de réaction du groupe de l'oxygène et de l'azote.

2. Utilisation d'un corps moulé consistant en un matériau contenant du silicium qui consiste en un matériau polycristallin coulé à l'état fondu et solidifié consistant en au moins 99 % de silicium avec des agents dopants du groupe du bore, de l'antimoine, du phosphore et de l'arsenic ajoutés à la masse fondue, comme cible pour la mise en oeuvre du procédé selon la revendication 1.

3. Utilisation d'un corps moulé selon la revendication 2, qui présente une résistance spécifique de 0,1 m$\Omega$cm à 100 $\Omega$cm.

4. Utilisation d'un corps moulé selon la revendication 3, qui présente une résistance spécifique de 0,5